# FASCICULE DE BREVET EUROPEEN

(11) **EP 3 297 136 B1**
(45) Date de publication et mention de la délivrance du brevet: **27.02.2019**
(21) Numéro de dépôt: 17186971.2
(22) Date de dépôt: 18.08.2017
(51) Int. Cl.: H02K 7/14, F16D 9/06, F16D 3/72, H02K 7/00

(54) **LIAISON ENTRE UN ROTOR DE MOTEUR ÉLECTRIQUE ET UN ÉLÉMENT À ENTRAINER**
VERBINDUNG ZWISCHEN EINEM ROTOR EINES ELEKTROMOTORS UND EINEM ANZUTREIBENDEN ELEMENT
METHOD FOR CONNECTING THE ROTOR OF AN ELECTRIC MOTOR TO AN ELEMENT THAT IS TO BE DRIVEN

(30) Priorité: 26.08.2016 FR 1657967
(43) Date de publication de la demande: 21.03.2018
(73) Titulaire: Safran Landing Systems, 78140 Vélizy-Villacoublay (FR)
(72) Inventeur: JABER, Sylvain, 78140 VELIZY-VILLACOUBLAY (FR); BELLENGER, Vincent, 78140 VELIZY-VILLACOUBLAY (FR); MORETTI, Nicolas, 78140 VELIZY-VILLACOUBLAY (FR); ELUARD, Gilles, 78140 VELIZY-VILLACOUBLAY (FR)
(74) Mandataire: Lavialle, Bruno François Stéphane

(56) Documents cités:
- DE-A1- 2 538 975
- JP-A- 2008 256 068

## Description

L'invention concerne un procédé pour relier le rotor d'un moteur électrique à un élément à entraîner, permettant une protection contre les couples importants, et permettant de vérifier le bon fonctionnement du moteur. Un procédé suivant le préambule de la revendication 1 est connu par le document DE-A1-25 38 975.

Le document JP-A-2008 256 068 décrit une liaison entre deux arbres comportant un arrangement de ressorts conduisant à une liaison élastique en rotation agissant dans les deux sens de rotation.

### ARRIERE PLAN DE L'INVENTION

Dans le domaine de l'aviation, il est proposé de motoriser les roues des aéronefs à l'aide de moteurs électriques pour permettre le déplacement de l'aéronef au sol sans utiliser ses groupes propulseurs. Cependant, lors de l'atterrissage, les roues sont brutalement mises en rotation, ce qui impose de protéger l'organe de sortie du moteur pour éviter tout endommagement, l'organe de sortie pouvant être le rotor du moteur si celui-ci est en prise directe, ou la sortie d'un réducteur interposé entre le rotor et la roue.

Il a été proposé d'interposer un embrayage à disques ou un crabot pour désolidariser sélectivement l'organe de sortie de la roue lors de l'atterrissage, et ne le solidariser à la roue que lorsque la vitesse de l'aéronef descend sous un seuil déterminé.

La désolidarisation permet de mettre en oeuvre différents types de test. En effet, quand la roue est désolidarisée du moteur, on peut alimenter le moteur pour vérifier s'il tourne bien, avec un courant d'alimentation restant sous un seuil déterminé pour une vitesse de rotation donnée. Ce test peut se faire au sol, ou préalablement à l'atterrissage. En outre, Il est possible, préalablement à l'atterrissage, de tester le couple résistant de la roue en la solidarisant à l'organe de sortie et en la faisant tourner, permettant de déceler un problème dans les roulements de la roue. Mais le poids de ces solutions est souvent rédhibitoire. Par ailleurs, ces dispositifs induisent des risques de panne à prendre en compte dans la conception de l'aéronef, ainsi que des opérations de maintenance (graissage, inspection, remplacement des éléments d'usure...).

Il a également été proposé d'utiliser des broches s'étendant entre l'organe de sortie et l'élément à entraîner, par exemple dans un montage de type à double chape, et calibrées pour céder en cisaillement lorsque le couple transmis par les broches dépasse un seuil déterminé (broches dites fusibles). Cette liaison est beaucoup plus simple et ne nécessite aucune maintenance, sauf le remplacement périodique des broches. Cependant, le moteur est en permanence solidarisé à la roue, empêchant tout test du moteur indépendamment de la roue. En effet, si, préalablement à l'atterrissage, on alimente le moteur et on détecte une résistance anormale, il est impossible de déterminer si la résistance vient du moteur ou de la roue.

### OBJET DE L'INVENTION

L'invention a pour objet un procédé de liaison par broches fusibles entre l'organe de sortie d'un moteur et un élément à entraîner en rotation, permettant néanmoins de tester le moteur indépendamment l'élément à entraîner.

### RESUME DE L'INVENTION

En vue de la réalisation de ce but, on propose un procédé pour relier en rotation un organe de sortie d'un moteur électrique avec un élément à entraîner en rotation, comprenant l'utilisation d'au moins une broche fusible qui lie l'organe de sortie et l'élément à entraîner et qui présente au moins une section susceptible de céder en cisaillement quand un couple transmis par la broche fusible dépasse un seuil prédéterminé. Selon l'invention, le procédé comporte l'étape d'interposer, entre la broche et l'un de l'organe de sortie ou de l'élément à entraîner, au moins un organe élastique comportant une première course avec une première raideur, suivie d'une deuxième course avec une deuxième raideur plus forte que la première raideur.

Ainsi, pour tester le bon fonctionnement du moteur, il suffit de bloquer l'élément à entraîner, et d'alimenter le moteur. Celui-ci doit normalement entraîner la broche à l'encontre de la première raideur de l'organe élastique. En surveillant le courant d'alimentation du moteur, il est possible de vérifier que le couple résistant du moteur reste sous un seuil déterminé, incluant la résistance opposée par l'organe élastique. Puis, une fois ce test effectué, l'élément à entraîner est libéré, et le moteur est de nouveau alimenté. En surveillant le courant d'alimentation du moteur, il est possible de vérifier que le couple résistant de l'ensemble tournant reste sous un seuil prédéterminé. Enfin, en fonctionnement, la deuxième course, avec la raideur plus forte, permet une montée progressive du couple de transmission après que l'organe élastique ait consommé la première course, en évitant tout accostage brutal.

Selon une caractéristique avantageuse de l'invention, la broche a ses deux extrémités engagées dans l'un de l'organe de sortie ou de l'élément à entraîner, et une partie centrale s'étendant dans l'autre de l'organe de sortie ou de l'élément à entraîner, l'organe élastique étant monté pour agir sur la partie centrale de la broche.

### BREVE DESCRIPTION DES DESSINS

L'invention sera mieux comprise à la lumière de la description d'un mode particulier de mise en oeuvre du procédé de l'invention, en référence aux figures des dessins annexés, parmi lesquelles :

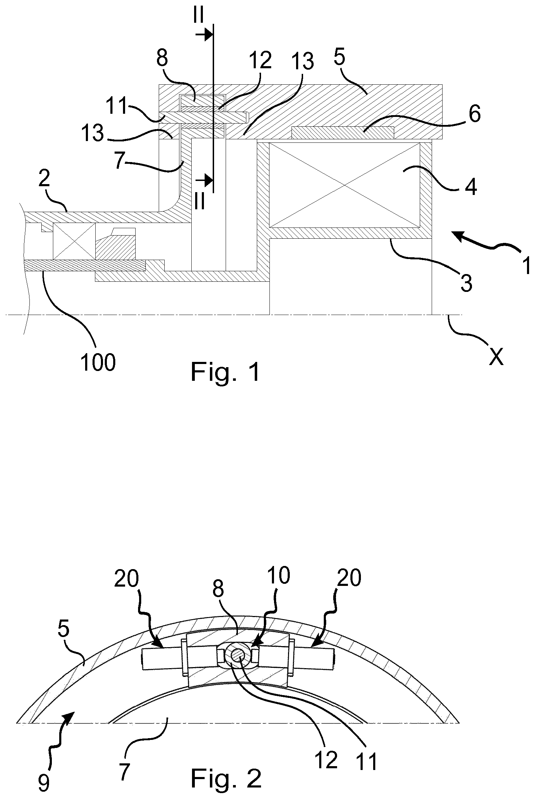

- La figure 1 est une vue en coupe schématique d'un moteur dont le rotor est accouplé à un élément à entraîner par une broche fusible ;
- La figure 2 est vue en coupe selon la ligne II-II de la figure 1 ;
- La figure 3 est une vue en coupe longitudinale de l'un des tampons élastiques interposés entre la broche et l'élément à entraîner.

### DESCRIPTION DETAILLEE DE L'INVENTION

L'invention s'applique à la liaison entre un moteur 1 et un élément à entraîner en rotation, par exemple ici une roue 2 d'aéronef dont on voit ici l'extrémité du moyeu et montée pour tourner sur une essieu 100 autour d'un axe de rotation X. Le moteur 1 est ici monté coaxialement à la roue 2 et comporte un stator 3 (fixé par exemple à l'essieu de la roue) recevant un bobinage 4. Le moteur comporte par ailleurs un rotor 5 monté tournant autour du stator 3 et comportant des aimants permanents 6 pour interagir électromagnétiquement avec le bobinage 4 du stator 3. A l'extrémité du moyeu de la roue 2 est fixé un flasque 7 dont la périphérie est munie d'une excroissance 8 qui est reçue dans une gorge 9 du rotor 5. L'excroissance est percée d'un orifice 10 de section oblongue dans laquelle s'étend une broche fusible 11, ici recouverte d'un manchon 12 sur sa partie centrale et dont les extrémités sont reçues dans des orifices ajustés ménagés dans des flancs 13 du rotor qui délimitent la gorge 9. L'excroissance 8 porte par ailleurs deux organes élastiques 20 qui sont fixés de part et d'autre de l'excroissance pour saillir dans l'orifice 10 et coopérer avec la broche fusible 11.

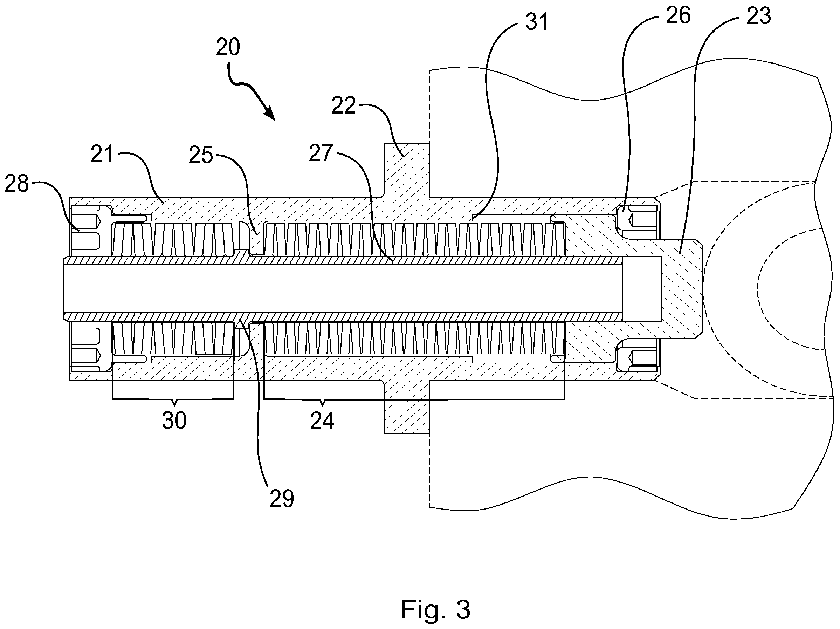

Comme cela est plus particulièrement visible à la figure 3, chaque organe élastique 20 comporte un corps cylindrique 21 dont l'extérieur est engagé dans un orifice de l'excroissance 8 jusqu'à butée d'une collerette 22 saillant du corps 21. Les moyens de fixation de l'organe élastique 20 à l'excroissance ne sont pas ici représentés. Chaque organe élastique 20 comporte un poussoir 23 monté coulissant dans le corps 21 tout en saillant d'une extrémité de celui-ci pour venir au contact de du manchon 12 de la broche fusible 11. Une première série de rondelles Belleville 24, définissant une première raideur, prend d'une part appui sur une face d'appui d'un diaphragme 25 s'étendant à l'intérieur du corps 21, et agit sur le poussoir 23 pour le pousser vers la broche fusible 11 en étant ici arrêté par un premier écrou d'arrêt 26 vissé dans une première extrémité du corps 21. Le poussoir 23 peut être enfoncé dans le corps 21 à l'encontre de l'effort généré par la première série de rondelles 24 jusqu'à buter sur l'extrémité d'un tube interne 27 qui passe au travers du diaphragme 25 de sorte qu'une extrémité opposée du tube 27 vienne coulisser dans un deuxième écrou d'arrêt 28 vissé dans une deuxième extrémité du corps 21. Le tube 27 comporte une collerette 29 qui est poussé contre le diaphragme 25 par une deuxième série de rondelles Belleville 30 prenant appui sur le deuxième écrou d'arrêt 28.

Lorsque le poussoir 23 est repoussé par la broche fusible 11, le poussoir 23 parcourt une première course lors de laquelle il est soumis à l'action de la première série de rondelles 24 qui impose une première raideur. La première course se termine quand le poussoir 23 accoste le tube 27. Puis le poussoir 23 parcourt une deuxième course lors de laquelle il repousse le tube 27 et est donc soumis à l'action de la deuxième série de rondelles 30 qui travaille en parallèle de la première série de rondelles 24 et qui ajoute donc sa raideur à la raideur de la première série de rondelles, de sorte que la raideur vue par le poussoir lors de cette deuxième course est supérieure à la première raideur. Cette deuxième course se termine quand le poussoir vient en butée contre un épaulement interne 31 du corps 21.

Le fonctionnement de l'ensemble est le suivant. Au repos, les poussoirs 23 des deux organes élastiques 20 appuient de part et d'autre du manchon 12 de la broche fusible 11 pour centrer celle-ci au milieu de l'orifice oblong. Les poussoirs 23 sont donc légèrement décollés de l'écrou 26.

Lors d'un test de bon fonctionnement du moteur 1, par exemple avant un atterrissage, on bloque la roue 2 en rotation (par exemple à l'aide du frein qui équipe la roue), et on alimente le bobinage 4 du moteur ce qui impose un couple sur le rotor 5 tendant à le faire tourner. Si le rotor 5 n'est pas bloqué (par exemple par un grippage des roulements du moteur) il provoque le déplacement de la broche fusible 11 dans l'orifice oblong 10 de sorte à repousser le poussoir 23 de l'un des organes élastiques 20 à l'encontre de sa première série de rondelles 24. Le courant d'alimentation du moteur suffit pour repousser l'un des poussoirs à l'encontre de l'effort développé par la première série de rondelles 24, mais n'est pas suffisante pour repousser le poussoir à l'encontre de l'effort exercé par la deuxième série de rondelles. Il est donc possible de détecter si le courant d'alimentation reste sous un seuil prédéterminé pour une course angulaire du rotor qui correspond à la première course de l'organe élastique sollicité. Si ce n'est pas le cas, c'est que quelque chose gêne la rotation du rotor, et une alerte de d'inspection est alors générée.

Puis on continue le test en libérant la roue, et en réalimentant le moteur 1 pour vérifier si la roue tourne librement. De la même façon, on détecte si le courant d'alimentation reste sous un seuil prédéterminé. Sous cette charge, les poussoirs ne sont pas repoussés, et la transmission de couple entre le rotor 5 et la roue 2 se fait sans que les organes élastique ne soient compressés.

En service, lors d'une transmission de couple entre le rotor et la roue 2, par exemple lors de la mise en rotation de la roue à l'atterrissage, ou lorsque le moteur est alimenté pour faire tourner la roue et déplacer l'aéronef au sol, l'un des poussoirs 23 est repoussé pour parcourir la première course, et s'engager dans la deuxième course, ce qui fait rapidement monter l'effort d'entraînement, sans toutefois donner lieu à un choc préjudiciable à la tenue des divers éléments sollicités. La deuxième série de rondelles sert ainsi de filtre et de protection contre les chocs à la montée en couple.

De préférence, la broche fusible 11 est dimensionnée pour résister en fatigue à des couples courants rencontrés dans l'utilisation normale de l'aéronef, mais pour céder en cisaillement si le couple transmis venait à dépasser un seuil donné, typiquement trois à cinq fois le couple de dimensionnement en fatigue, ceci afin de protéger le moteur et éviter tout effort sur la roue tendant à bloquer celle-ci de façon non désirée.

L'invention n'est pas limitée à ce qui vient d'être décrit, mais englobe au contraire toute variante entrant dans le cadre défini par les revendications. En particulier, on pourra prévoir plusieurs broches fusibles pour relier l'organe de sortie du moteur à l'élément à entraîner en rotation, chaque broche étant associée à au moins un organe élastique, un seul étant suffisant si le couple transmis est toujours de même sens. Les organes élastiques pourront être montés soit sur l'élément à entraîner comme décrit ici, soit sur l'organe de sortie du moteur.

Bien que les moyens élastiques présentés ici soient des séries de rondelles Belleville, on pourra utiliser d'autres moyens élastiques, comme des ressorts hélicoïdaux. On pourra y adjoindre un moyen d'amortissement.

## Revendications

1. Procédé pour relier en rotation un organe de sortie (5) d'un moteur électrique (1) avec un élément (2) à entraîner en rotation, comprenant l'utilisation d'au moins une broche fusible (11) qui lie l'organe de sortie et l'élément à entraîner et qui présente au moins une section susceptible de céder en cisaillement quand un couple transmis par la broche fusible dépasse un seuil prédéterminé, **caractérisé en ce que** le procédé comporte l'étape d'interposer, entre la broche et l'un de l'organe de sortie ou de l'élément à entraîner, au moins un organe élastique (20) comportant une première course avec une première raideur, suivie d'une deuxième course avec une deuxième raideur plus forte que la première raideur.

2. Procédé selon la revendication 1, dans lequel la broche a ses deux extrémités engagées dans l'un de l'organe de sortie ou de l'élément à entraîner, et une partie centrale s'étendant dans l'autre de l'organe de sortie ou de l'élément à entraîner, l'organe élastique étant monté pour agir sur la partie centrale de la broche.

3. Procédé selon la revendication 1, dans lequel l'organe élastique (20) comporte un corps (21) dans lequel un poussoir est monté pour coulisser et saillir du corps pour coopérer avec la broche fusible (11), le poussoir pouvant être repoussé par la broche fusible à l'encontre d'un premier moyen élastique (24) puis après la première course, à l'encontre d'une deuxième moyen élastique (30) agissant en parallèle avec le premier moyen élastique.

4. Procédé selon la revendication 3, dans lequel le premier moyen élastique (24) est disposé entre le corps et le poussoir pour repousser celui-ci, tandis que le deuxième moyen élastique (30) est disposé entre le corps et un tube interne (27) sur lequel le poussoir vient buter à la fin de la première course.

5. Procédé de test de bon fonctionnement du moteur électrique relié à un élément à entraîner selon le procédé de liaison conforme à l'une quelconque des revendications précédentes, comprenant l'étape de bloquer en rotation l'élément à entraîner, d'alimenter le moteur avec un courant d'alimentation, et de vérifier si, pour une course angulaire du moteur correspondant à la première course de l'organe élastique, le courant d'alimentation ne dépasse pas un seuil prédéterminé.

6. Procédé de test de bon fonctionnement de l'élément à entraîner relié à l'organe de sortie d'un moteur selon le procédé de liaison conforme à l'une des revendications 1 à 4, comportant l'étape, après avoir fait le test de la revendication 5, d'alimenter le moteur avec un courant d'alimentation, et de vérifier si le courant d'alimentation ne dépasse pas un seuil prédéterminé.

## Patentansprüche

1. Verfahren zur Drehverbindung eines Abtriebselements (5) eines Elektromotors (1) mit einem in Drehung anzutreibenden Element, umfassend die Verwendung mindestens eines Scherstiftes (11), der das Abtriebselement und das anzutreibende Element verbindet und der mindestens einen Querschnitt aufweist, der unter Scherbeanspruchung brechen kann, wenn ein von dem Scherstift übertragenes Drehmoment einen vorbestimmten Schwellwert überschreitet, **dadurch gekennzeichnet, dass** das Verfahren den Schritt des Einfügens mindestens eines elastischen Elements (20) zwischen dem Stift und dem Abtriebselement oder dem anzutreibenden Element umfasst, wobei das elastische Element (20) einen ersten Hub mit einer ersten Steifigkeit, gefolgt von einem zweiten Hub mit einer zweiten Steifigkeit umfasst, die höher als die erste Steifigkeit ist.

2. Verfahren nach Anspruch 1, bei dem der Stift mit seinen beiden Enden in das Abtriebselement oder das anzutreibende Element eingreift und sich ein Mittelteil in dem jeweils anderen Element erstreckt, wobei das elastische Element so angebracht ist, dass es auf den Mittelteil des Stiftes einwirkt.

3. Verfahren nach Anspruch 1, bei dem das elastische Element (20) ein Gehäuse (21) umfasst, in dem ein Stößel verschiebbar und aus dem Gehäuse vorstehend gelagert ist, um mit dem Scherstift (11) zusammenzuarbeiten, wobei der Stößel von dem Scherstift entgegen einem ersten elastischen Mittel (24) zurückgestoßen werden kann, und daraufhin nach dem ersten Hub entgegen einem zweiten elastischen Mittel (30), das parallel zum ersten elastischen Element wirkt.

4. Verfahren nach Anspruch 3, bei dem das erste elastische Mittel (24) zwischen dem Gehäuse und dem Stößel angeordnet ist, um diesen zurückzustoßen, während das zweite elastische Mittel (30) zwischen dem Gehäuse und einem Innenrohr (27) angeordnet ist, an dem der Stößel am Ende des ersten Hubes zur Anlage kommt.

5. Verfahren zum Testen des ordnungsgemäßen Funktionierens des Elektromotors, der mit einem anzutreibenden Element gemäß dem Verbindungsverfahren nach einem der vorhergehenden Ansprüche verbunden ist, umfassend den Schritt des Blockierens des anzutreibenden Elements in Drehung, des Versorgens des Motors mit einem Versorgungsstrom und des Prüfens, ob für einen Winkelhub des Motors, der dem ersten Hub des elastischen Elements entspricht, der Versorgungsstrom einen vorbestimmten Schwellwert nicht überschreitet.

6. Verfahren zum Testen des ordnungsgemäßen Funktionierens des anzutreibenden Elements, das mit dem Abtriebselement eines Motors gemäß dem Verbindungsverfahren nach einem der Ansprühe 1 bis 4 verbunden ist, umfassend nach der Durchführung des Tests des Anspruchs 5 den Schritt des Versorgens des Motors mit einem Versorgungsstrom und des Prüfens, ob der Versorgungsstrom einen vorbestimmten Schwellwert nicht überschreitet.

## Claims

1. Method for connecting in rotation an output member (5) of an electric motor (1) and an element (2) that is to be driven in rotation, comprising the use of at least one fusible pin (11) that links the output member and the element that is to be driven, and that has at least one section that is prone to fail in shear when a torque transmitted by the fusible pin exceeds a predetermined threshold, **characterized in that** the method comprises the step of interposing, between the pin and either the output member or the element that is to be driven, at least one elastic member (20) comprising a first travel with a first stiffness followed by a second travel with a second stiffness greater than the first stiffness.

2. Method according to Claim 1, in which the two ends of the pin are engaged in one of the output member or the element that is to be driven, and a central portion of the pin extends in the other of the output member or the element that is to be driven, the elastic member being mounted so as to act on the central portion of the pin.

3. Method according to Claim 1, in which the elastic member (20) comprises a body (21) in which a pusher is mounted so as to slide and project from the body in order to engage with the fusible pin (11), wherein the pusher can be pushed back by the fusible pin counter to a first elastic means (24) then, after the first travel, counter to a second elastic means (30) acting in parallel with the first elastic means.

4. Method according to Claim 3, in which the first elastic means (24) is arranged between the body and the pusher in order to push back the latter, while the second elastic means (30) is arranged between the body and an internal tube (27) against which the pusher comes to abut at the end of the first travel.

5. Method for testing the proper operation of the electric motor, connected to an element that is to be driven as per the connecting method according to any one of the preceding claims, comprising the step of blocking the rotation of the element that is to be driven, supplying a supply current to the motor, and verifying whether, for an angular travel of the motor corresponding to the first travel of the elastic member, the supply current does not exceed a predetermined threshold.

6. Method for testing the proper operation of the element that is to be driven, connected to the output member of a motor as per the connecting method according to one of Claims 1 to 4, comprising the step, after carrying out the test of Claim 5, of supplying a supply current to the motor, and verifying whether the supply current does not exceed a predetermined threshold.
